# EUROPÄISCHE PATENTSCHRIFT

(11) **EP 1 980 059 B1**
(45) Veröffentlichungstag und Bekanntmachung des Hinweises auf die Patenterteilung: **01.10.2014**
(21) Anmeldenummer: 06819460.4
(22) Anmeldetag: 14.11.2006
(51) Int. Cl.: H04L 12/40, H02J 13/00, H02J 3/38

(54) **KOMMUNIKATIONSSTRUKTUR FÜR SOLARWECHSELRICHTER**
COMMUNICATION STRUCTURE FOR SOLAR INVERTERS
STRUCTURE DE COMMUNICATION POUR UN ONDULEUR SOLAIRE

(30) Priorität: 30.01.2006 DE 102006004233
(43) Veröffentlichungstag der Anmeldung: 15.10.2008
(73) Patentinhaber: Siemens Aktiengesellschaft, 80333 München (DE)
(72) Erfinder: EKLUND, Mats, A-1120 Wien (AT); HACKL, Franz, A-1130 Wien (AT); REITHMAYER, Franz, A-1110 Wien (AT); STROBL, Walter, A-1030 Wien (AT)
(74) Vertreter: Maier, Daniel Oliver
(86) Internationale Anmeldenummer: PCT/EP2006/068441
(87) Internationale Veröffentlichungsnummer: WO 2007/085310

(56) Entgegenhaltungen:
- WO-A-2005/117245
- DE-A1- 19 504 587
- DE-A1- 19 711 958
- APOSTOLOV A P ED - INSTITUTE OF ELECTRICAL AND ELECTRONICS ENGINEERS: "Integration of legacy intelligent electronic devices in UCA based digital control systems" 2002 IEEE POWER ENGINEERING SOCIETY. WINTER MEETING. CONFERENCE PROCEEDINGS. NEW YORK, NY, JAN. 27 - 31, 2002, IEEE POWER ENGINEERING SOCIETY, NEW YORK, NY : IEEE, US, Bd. VOL. 2 OF 2, 27. Januar 2002 (2002-01-27), Seiten 648-653, XP010578366 ISBN: 0-7803-7322-7
- SCHMIDT T: "ENHANCING AUTOMOTIVE SUBSYSTEM DESIGN WITH LIN" CIRCUIT CELLAR INK, CIRCUIT CELLAR INC., VERNON, CT,, US, Nr. 127, Februar 2001 (2001-02), Seiten 60-62,65, XP008004109 ISSN: 0896-8985

## Beschreibung

Die Erfindung betrifft eine Kommunikationsstruktur für wenigstens zwei Solarwechselrichter, wobei wenigstens ein erster Solarwechselrichter mittels eines für LAN-Netzwerke geeigneten ersten Übertragungsmediums über eine LAN-Schnittstelle mit einem Kommunikationsnetz verbunden ist.

Solarwechselrichter dienen der Umwandlung eines von Solarpaneelen gelieferten Gleichstroms in einen Wechselstrom zur Einspeisung in ein öffentliches Stromnetz oder in ein Inselstromnetz. Dabei verfügen Solarwechselrichter in der Regel über Messschaltungen, mittels welcher der Betriebsstatus erfasst und aufgezeichnet werden kann sowie über diverse Einstellmöglichkeiten. Eine Abfrage von Messdaten (z.B. Verlauf der Eingangsspannung, Umgewandelte Energie etc.) und Änderungen von Einstellungen (z.B. Standby-Zeiten) kann entweder durch eine direkte Verbindung eines Solarwechselrichters mit einem Eingabe/Auslese-Gerät oder mittels einer Anbindung an ein Kommunikationsnetz erfolgen. Im letzteren Fall bildet das Eingabe/Auslese-Gerät einen Knoten des Kommunikationsnetzes und die Datenübertragung erfolgt über dessen physikalische Struktur. Als Kommunikationsnetz wird beispielsweise das World Wide Web genutzt, es kann aber auch ein Intranet oder ein Extranet zum Einsatz kommen.

Nach dem Stand der Technik verfügt eine Photovoltaikanlage entweder über eine Kommunikationszentrale, an die alle Solarwechselrichter der Anlage angeschaltet sind oder jeder Solarwechselrichter umfasst eine eigene Kommunikationseinheit, die eine direkte Anbindung an ein Kommunikationsnetz erlaubt.

So beschreibt beispielsweise die DE 198 59 732 A1 eine Photovoltaikanlage mit einer Vielzahl von Solarmodulen und einer Zentrale, wobei jedem Solarmodul ein Wechselrichter zugeordnet ist und jeder Wechselrichter über eine Wechselstrom-Netzleitung mit der Zentrale verbunden ist. Über die Netzleitung werden sowohl Daten als auch die von den Solarmodulen erzeugte Energie im Zeitmultiplexverfahren übertragen. Dabei können die einzelnen Wechselrichter nur über die Zentrale mit einem öffentlichen Stromnetz verbunden werden, die ganze Anlage funktioniert demnach nur bei einem ordnungsgemäßen Betrieb der Zentrale. Die Datenübertragung dient dabei nur der Diagnose des Betriebszustandes der Solarmodule mit den jeweiligen Wechselrichtern. Steuerbefehle (z.B. Ein-/Ausschalten) sind nur für die gesamte Anlage durch Einstellungsänderungen an der Zentrale möglich, die Steuerbarkeit einzelner Solarwechselrichter ist nicht vorgesehen.

Die US 2004/0027004 A1 offenbart eine allgemeine Kommunikationsstruktur für dezentrale Stromerzeugungseinheiten. Dabei verfügt entweder jede Stromerzeugungseinheit oder mehrere Gruppen von Stromerzeugungseinheiten über jeweils einen Controller, wobei alle Controller mit einem Kommunikationsnetz verbunden sind. Zur Verbindung mit dem Kommunikationsnetz verfügt jeder Controller über eine Kommunikationseinheit (z.B. Modem), über die Kommunikationsvorgänge abgewickelt werden. Eine derartige Kommunikationsstruktur setzt voraus, dass jeder Controller zumindest über eine Telefonleitung oder ein Netzwerkkabel an das Kommunikationsnetz angebunden ist. Diese Leitungen sind meist sehr dünn und vieldrahtig, weshalb ihre Verlegung zur Vermeidung von Kabelschäden sehr sorgfältig geschehen muss. Eine derartige Verkabelung von Wechselrichtern für Solarmodule, welche naturgemäß im Gelände und auf Gebäuden verstreut aufgestellt und oft nicht frei zugänglich sind, ist deshalb mit einigem Aufwand verbunden. Bei einer Ethernetanbindung ist zudem die Leitungslänge ohne entsprechende Repeater beschränkt.

Die WO 2005/117245 A1 offenbart eine Kommunikationsstruktur für mehrere Solarwechselrichter. Dabei weist jeder Solarwechselrichter eine Busanschaltung auf, welche zum Beispiel zur Kommunikation mit einem LAN ausgebildet ist.

Der Erfindung liegt deshalb die Aufgabe zugrunde, eine Kommunikationsstruktur für Solarwechselrichter anzugeben, die eine Verbesserung gegenüber dem Stand der Technik darstellt.

Erfindungsgemäß wird diese Aufgabe durch eine Kommunikationsstruktur der eingangs genannten Art gelöst, wobei wenigstens ein weiterer Solarwechselrichter mit dem ersten Solarwechselrichter über busfähige serielle Schnittstellen und ein entsprechendes Übertragungsmedium verbunden ist und dass jeder Solarwechselrichter einen Web-Server umfasst.

Ein Vorteil dieser Lösung liegt darin, dass innerhalb einer Photovoltaikanlage mittels des ersten Teils der Solarwechselrichter eine effiziente Anbindung an ein Kommunikationsnetz wie beispielsweise das World Wide Web über LAN-Schnittstellen erfolgt. Darüber hinaus ist der weitere Teil mit dem ersten Teil über serielle Schnittstellen mit einem einfachen Übertragungsmedium (z.B. Zweidrahtleitung) verbunden, welches robuster als eine Telefon- oder Netzwerkleitung und über weitere Strecken hinweg installierbar ist. Es sind also zwei unterschiedliche Netzwerktypen vorgesehen, wobei der erste für Standard-LAN-Technologien mit schneller Datenübertragung auf kurzen Distanzen und der zweite für störunempfindliche Datenübertragung über lange Distanzen geeignet ist.

Eine vorteilhafte Ausprägung der Erfindung sieht dabei vor, dass die mit dem Kommunikationsnetz verbundenen Solarwechselrichter jeweils als Kommunikationsmaster ausgebildet sind und dass die weiteren Solarwechselrichter als Kommunikationsslaves ausgebildet sind. Der erste Netzwerktyp ist dann für die Kommunikation zwischen Kommunikationsmaster und Kommunikationsnetz und der zweite Netzwerktyp für die Kommunikation zwischen Kommunikationsmaster und Kommunikationsslaves optimiert. Auf diese Weise kann auf alle Solarwechselrichter über Kommunikationseinrichtungen, die als Knoten des Kommunikationsnetzes ausgebildete sind, zugegriffen werden. Es sind also einerseits Mess- bzw. Statusdaten jedes Solarwechselrichters abrufbar und andererseits Einstellungsänderungen an jedem Solarwechselrichter durch Übermittlung von Steuerungsdaten möglich. Der Zugriff erfolgt dabei für den ersten Teil der Solarwechselrichter direkt, für die weiteren Solarwechselrichter nach dem Master-Slave-Prinzip über die als Kommunikationsmaster ausgebildeten Solarwechselrichter. Dabei sind entweder nur die Kommunikationsmaster als Web-Server ausgebildet oder es sind auch die Kommunikationsslaves als Web-Server ausgebildet und die Kommunikationsmaster übernehmen eine Routerfunktion.

Vorteilhaft ist es des Weiteren, wenn die LAN-Schnittstelle als Ethernet-Schnittstelle und wenn die serielle Schnittstelle als EIA-485-Schnittstelle ausgebildet ist. Beide Schnittstellen sind sehr gängig und verlässlich, wobei die Ethernet-Schnittstelle besonders für eine effiziente Kommunikation mit einem Kommunikationsnetz und die EIA-485-Schnittstelle für eine robuste Verbindung über längere Verbindungen im freien Feld geeignet ist.

Von Vorteil ist es zudem, wenn zu jedem Kommunikationsmaster wenigstens ein Ersatz-Kommunikationsmaster vorgesehen ist, der im ordnungsgemäßen Betrieb als Kommunikationsslave arbeitet und im Fehlerfall die Funktion des Kommunikationsmasters übernimmt. Der Ersatz-Kommunikationsmaster verfügt dann auch über eine direkte LAN-Anbindung, die bei Ausfall des Kommunikationsmasters aktiviert wird und somit weiterhin den Datenaustausch mit jedem Solarwechselrichter innerhalb der Anlage ermöglicht.

Eine weitere Ausprägung der Erfindung sieht vor, dass zwischen das Kommunikationsnetz und die Kommunikationsmaster ein Router geschaltet ist. Mehrere in räumlicher Nähe angeordnete Photovoltaikanlagen können dann mit wenigstens einem Kommunikationsmaster pro Anlage über einen gemeinsamen Router an ein Kommunikationsnetz angebunden werden. Das vereinfacht die Kommunikationsanbindung der Anlagen und bewirkt eine effiziente Adressierung der einzelnen Solarwechselrichter.

Weiter Vorteile sind gegeben, wenn alle Solarwechselrichter baugleich ausgeführt sind. Das vereinfacht einerseits die Fertigung der Solarwechselrichter und flexibilisiert die Strukturierung von Photovoltaikanlagen. Beispielsweise sind dann alle Solarwechselrichter über die serielle Schnittstelle miteinander zusammenschaltbar und es wird jener Solarwechselrichter als Kommunikationsmaster definiert, der einem Kommunikationsnetzanschluss räumlich am nächsten ist. Auch die Festlegung von Ersatz-Kommunikationsmaster kann auf diese Weise einfach geändert werden.

Betrieben wird die erfindungsgemäße Kommunikationsstruktur, indem nur die Web-Server der als Kommunikationsmaster ausgebildeten Solarwechselrichter aktiv sind und alle aus dem Kommunikationsnetz über die LAN-Schnittstellen an die als Kommunikationsmaster ausgebildeten Solarwechselrichter übermittelten Daten von diesen gesammelt werden und indem diese Daten entsprechend einer Adresszuordnung an die als Kommunikationsslave ausgebildeten Solarwechselrichter geschickt werden. Zudem werden die Daten eines als Kommunikationsslave ausgebildeten Solarwechselrichters vom als Kommunikationsmaster ausgebildeten Solarwechselrichter abgerufen und über die LAN-Schnittstelle an einen Knoten im Kommunikationsnetz geschickt. Der Kommunikationsmaster fungiert somit als Web-Server für alle Solarwechselrichter, somit können z.B. Speicherfunktionen zentral beim Kommunikationsmaster implementiert sein. Dabei kann jeder Kommunikationsmaster und auch jeder Kommunikationsslave von sich aus jederzeit Informationen, beispielsweise als E-Mail, ins Kommunikationsnetz abschicken.

Ein anderes Verfahren zum Betreiben der erfindungsgemäßen Kommunikationsstruktur sieht vor, dass die Web-Server aller Solarwechselrichter aktiv sind und alle Daten aus dem Kommunikationsnetz über die als Kommunikationsmaster ausgebildeten Solarwechselrichter entsprechend einer Adresszuordnung an die als Kommunikationsslave ausgebildeten Solarwechselrichter weitergeleitet werden und dass die von einem als Kommunikationsslave ausgebildeten Solarwechselrichter gesendeten Daten über den zugeordneten, als Kommunikationsmaster ausgebildeten Solarwechselrichter an einen Knoten im Kommunikationsnetz weitergeleitet werden. Dabei ist jeder Solarwechselrichter als Web-Server aktiv und verwaltet die eigenen Daten selbst. Der Kommunikationsmaster dient dabei als Router, der die Daten entsprechend zugeordneter Solarwechselrichter-Adressen verteilt.

Bei beiden Verfahren ist es vorteilhaft, wenn im ordnungsgemäßen Betrieb alle Daten der jeweils einem Kommunikationsmaster zugeordneten Kommunikationsslaves über diesen Kommunikationsmaster abgewickelt werden und wenn bei einem Ausfall dieses Kommunikationsmasters alle Daten über einen Ersatz-Kommunikationsmaster abgewickelt werden.

Die Erfindung wird nachfolgend in beispielhafter Weise unter Bezugnahme auf die beigefügten Figuren erläutert. Es zeigen in schematischer Darstellung:
- Fig. 1: Kommunikationsstruktur einer Photovoltaikanlage
- Fig. 2: Kommunikationsstruktur einer Photovoltaikanlage mit zwei Strängen und einem Router

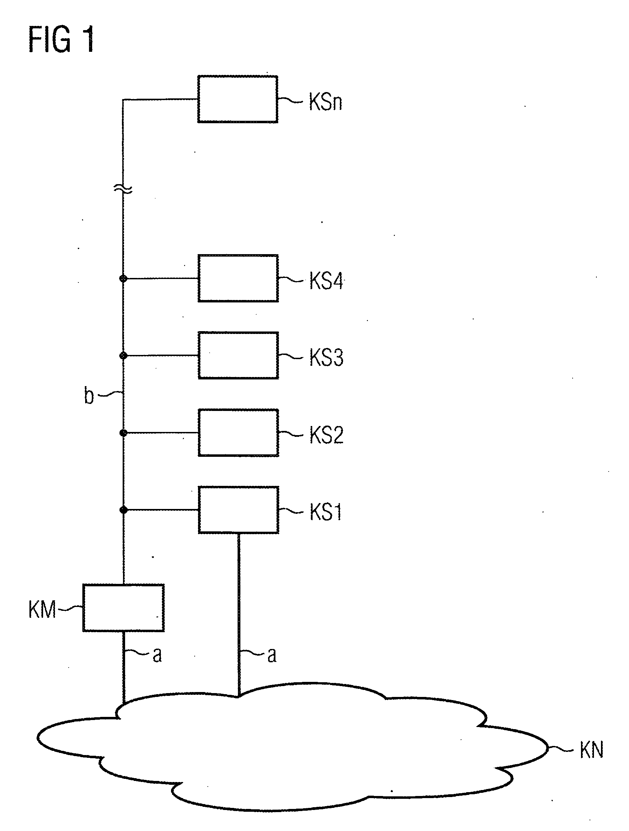

In Figur 1 ist eine erfindungsgemäße Ausprägung einer Kommunikationsstruktur für eine Photovoltaikanlage dargestellt, wobei die einzelnen Solarwechselrichter KM, KS1...KSn zur besseren Übersichtlichkeit ohne die angeschlossenen Solarpaneele und ohne die Leistungsanschlüsse an ein Stromnetz dargestellt sind. Den einzelnen Solarwechselrichtern KM, KS1...KSn sind beispielsweise Solarpaneelen mit einer Leistung von bis zu 5 KW zugeordnet, so dass eine effiziente Anlage mehrere Solarwechselrichter in räumlicher Nähe umfasst. Die als Kommunikationsslaves KS1 bis KSn ausgebildeten Solarwechselrichter sind dabei über ein für serielle Netzwerke geeignetes Übertragungsmedium b miteinander über eine busfähige serielle Schnittstelle verbunden (z.B. über eine EIA-485-Schnittstelle). Das für serielle Netzwerke geeignete Übertragungsmedium b kann beispielsweise eine Zweidraht-Kupferleitung sein, die EIA-485-Schnittstelle arbeitet dann im Halbduplexverfahren.

Es können dabei beispielsweise bis zu 100 Kommunikationsslaves KS1 bis KSn in einer Anlage angeordnet sein, wobei die Entfernung zwischen den einzelnen Solarwechselrichtern in etwa 1km betragen kann. Ein Ende des für serielle Netzwerke geeigneten Übertragungsmediums b ist mit der seriellen Schnittstelle des als Kommunikationsmaster KM ausgebildeten Solarwechselrichters verbunden.

Der als Kommunikationsmaster KM ausgebildete Solarwechselrichter ist über eine zusätzliche LAN-Schnittstelle mit einem für LAN-Netzwerke geeigneten Übertragungsmedium a an ein Kommunikationsnetz KN angeschaltet. Dieses für LAN-Netzwerke geeignete Übertragungsmedium a kann beispielsweise ein Netzwerkkabel sein, wobei der Kommunikationsmaster KM über eine Ethernet-Schnittstelle mit dem Kommunikationsnetz KN verbunden wird. Der Kommunikationsmaster KM kann aber auch über ein Modem an das Kommunikationsnetz KN angeschlossen werden, das für LAN-Netzwerke geeignete Übertragungsmedium a ist dann ein Telefonkabel.

Ein als Kommunikationsslave KS1 ausgebildeter Solarwechselrichter ist ebenfalls über eine LAN-Schnittstelle mit einem für LAN-Netzwerke geeigneten Übertragungsmedium a an das Kommunikationsnetz KN angeschaltet. Dieser Kommunikationsslave KS1 dient dann als Ersatz-Kommunikationsmaster, der die Funktion des Kommunikationsmasters KM übernimmt, falls dieser ausfällt. Um die Ausfallsicherheit zu erhöhen, können auch noch weitere Kommunikationsslaves als Ersatz-Kommunikationsmaster mit einem für LAN-Netzwerke geeigneten Übertragungsmedium a über die LAN-Schnittstelle mit dem Kommunikationsnetz KN verbunden sein.

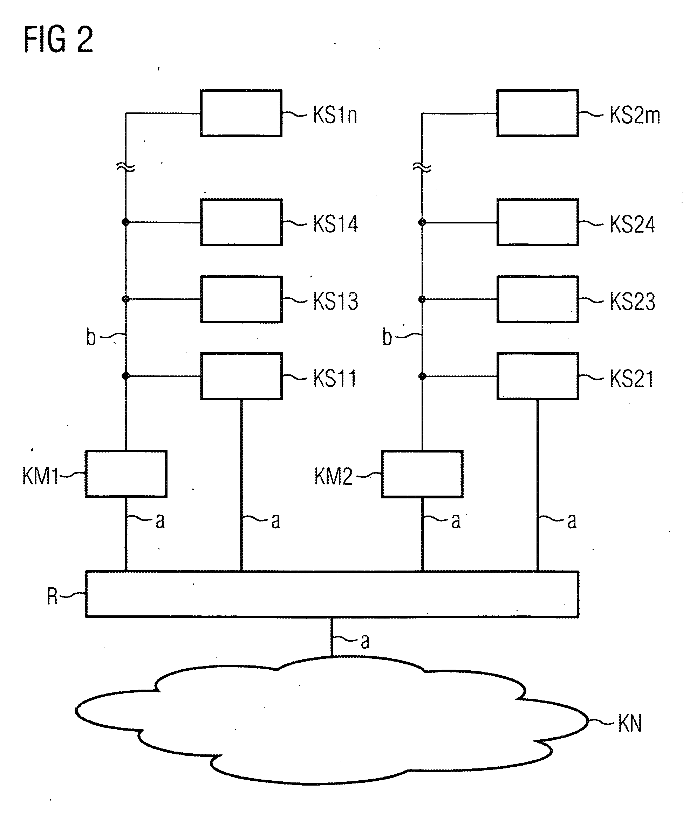

In Figur 2 ist eine Photovoltaikanlage mit zwei Strängen dargestellt, wobei jeder Strang aus einem als Kommunikationsmaster KM1, KM2 ausgebildeten Solarwechselrichter mit zugeordneten Solarwechselrichtern als Kommunikationsslaves KS11...KS1n bzw. KS21...KS2m ausgebildet ist. Dieselbe Anordnung liegt auch bei zwei oder mehreren in räumlicher Nähe errichteten Photovoltaikanlagen mit jeweils einem oder mehreren Strängen vor. Jeder als Kommunikationsmaster KM1, KM2 ausgebildete Solarwechselrichter ist dabei mit einem Router R verbunden. Die Anzahl der angeschlossenen Stränge bzw. Photovoltaikanlagen hängt dabei von der Bauart des Routers R ab.

Im ersten Strang ist ein Kommunikationsmaster KM1 über eine LAN-Schnittstelle mit einem für LAN-Netzwerke geeigneten Übertragungsmedium a an den Router R angebunden, ebenso ein als Ersatz-Kommunikationsmaster KS11 ausgebildeter Solarwechselrichter. Alle Solarwechselrichter KM1, KS11...KS1n eines ersten Strangs sind zudem über eine serielle Schnittstelle mit einem für serielle Netzwerke geeigneten Übertragungsmedium b miteinander verbunden. Der zweite Strang ist in gleicher Weise angeordnet, wobei hier die Anzahl der als Kommunikationsslaves ausgebildeten Solarwechselrichter KS21 bis KS2m von jener des ersten Strangs abweichen kann. Der Router R ist über eine weitere LAN-Schnittstelle mit einem für LAN-Netzwerke geeigneten Übertragungsmedium a an das Kommunikationsnetz KN angeschaltet. Alle Daten werden über diese Leitung zwischen Kommunikationsnetz KN und Router R übertragen und vom Router R dem richtigen Kommunikationsmaster KM1, KM2 bzw. im Störfall einem Ersatz-Kommunikationsmaster KS11, KS21 zugeordnet. Die Zuordnung erfolgt dabei in der Regel über eine eindeutige Adresse jedes Solarwechselrichters, mit der jeder Datenblock gekennzeichnet ist.

Der Zugriff aus dem Kommunikationsnetz KN (z.B. Internet) auf die Solarwechselrichter kann auf zwei unterschiedliche Arten erfolgen:
a) Es sind nur die Kommunikationsmaster KM bzw. KM1, KM2 direkt vom Kommunikationsnetz KN aus ansprechbar. Ein angesprochener Kommunikationsmaster KM bzw. KM1, KM2 sammelt die Daten der Kommunikationsslaves KS1...KSn bzw. KS11...KS1n, KS21...KS2m über die serielle Schnittstelle mit dem für serielle Netzwerke geeigneten Übertragungsmedium b als Verbindungsleitung. Die Kommunikationsslaves KS1...KSn bzw. KS11...KS1n, KS21...KS2m sind auf diese Weise indirekt mit dem Kommunikationsnetz KN verbunden. In diesem Fall sind nur die Web-Server der Kommunikationsmaster KM bzw. KM1,KM2 aktiv.
b) Der Kommunikationsmaster KM bzw. KM1, KM2 baut über die serielle Schnittstelle mit dem für serielle Netzwerke geeigneten Übertragungsmedium b als Verbindungsleitung eine Netzwerkverbindung zu den Kommunikationsslaves KS1...KS1n bzw. KS11...KS1n, KS21...KS2m in der Weise auf, dass jeder Solarwechselrichter direkt über das Kommunikationsnetz KN erreichbar ist. In diesem Fall sind sowohl die Web-Server der Kommunikationsmaster KM bzw. KM1, KM2 als auch jene der Kommunikationsslaves KS1...KSn bzw. KS11...KS1n, KS21...KS2m aktiv. Es ist günstig, jeden Solarwechselrichter baugleich auszuführen. Jeder Solarwechselrichter umfasst somit einen Web-Server, der aktiviert oder deaktiviert sein kann. Eine Anlage ist dann unabhängig von zukünftigen Kommunikationsanforderungen einsetzbar und jeder Solarwechselrichter kann entweder die Funktion eines Kommunikationsmasters KM1 bzw. KM2 oder eines Kommunikationsslaves KS1...KSn bzw. KS11...KS1n, KS21...KS2m übernehmen. Im Falle der Ersatz-Kommunikationsmaster KS11 bzw. KS21 ist damit auch in einfacher Weise eine Wechsel zwischen den Funktionen möglich.

## Patentansprüche

1. Kommunikationsstruktur für wenigstens zwei Solarwechselrichter (KM, KS1...KSn bzw. KM1, KM2, KS11...KS1n, KS21...KS2m), wobei wenigstens ein erster Solarwechselrichter (KM bzw. KM1, KM2) mittels eines für LAN-Netzwerke geeigneten ersten Übertragungsmediums (a) über eine LAN-Schnittstelle mit einem Kommunikationsnetz (KN) verbunden ist **dadurch gekennzeichnet, dass** wenigstens ein weiterer Solarwechselrichter (KS1...KSn bzw. KS11...KS1n, KS21...KS2m) mit dem ersten Solarwechselrichter (KM bzw. KM1, KM2) über busfähige serielle Schnittstellen und ein entsprechendes zweites Übertragungsmedium (b) verbunden ist und dass jeder Solarwechselrichter (KM, KS1...KSn bzw. KM1, KM2, KS11...KS1n, KS21...KS2m) einen Web-Server umfasst.

2. Kommunikationsstruktur nach Anspruch 1, **dadurch gekennzeichnet, dass** die mit dem Kommunikationsnetz (KN) verbundenen Solarwechselrichter jeweils als Kommunikationsmaster (KM bzw. KM1, KM2) ausgebildet sind und dass die weiteren Solarwechselrichter als Kommunikationsslaves (KS1...KSn bzw. KS11...KS1n, KS21...KS2m) ausgebildet sind.

3. Kommunikationsstruktur nach Anspruch 1 oder 2, **dadurch gekennzeichnet, dass** die LAN-Schnittstelle als Ethernet-Schnittstelle und dass die serielle Schnittstelle als EIA-485-Schnittstelle ausgebildet ist.

4. Kommunikationsstruktur nach einem der Ansprüche 1 bis 3, **dadurch gekennzeichnet, dass** zu jedem Kommunikationsmaster (KM bzw. KM1, KM2) wenigstens ein Ersatz-Kommunikationsmaster (KS1 bzw. KS11, KS21) vorgesehen ist, der im ordnungsgemäßen Betrieb als Kommunikationsslave arbeitet und im Fehlerfall die Funktion des Kommunikationsmasters übernimmt.

5. Kommunikationsstruktur nach einem der Ansprüche 1 bis 4, **dadurch gekennzeichnet, dass** zwischen das Kommunikationsnetz (KN) und die Kommunikationsmaster (KM bzw. KM1, KM2) ein Router geschaltet ist.

6. Kommunikationsstruktur nach einem der Ansprüche 1 bis 5, **dadurch gekennzeichnet, dass** alle Solarwechselrichter (KM, KS1...KSn bzw. KM1, KM2, KS11...KS1n, KS21...KS2m) baugleich ausgeführt sind.

7. Verfahren zum Betrieb einer Kommunikationsstruktur nach einem der Ansprüche 1 bis 6, **dadurch gekennzeichnet, dass** nur die Web-Server der als Kommunikationsmaster (KM bzw. KM1, KM2) ausgebildeten Solarwechselrichter aktiv sind und alle aus dem Kommunikationsnetz (KN) über die LAN-Schnittstellen an die als Kommunikationsmaster (KM bzw. KM1, KM2) ausgebildeten Solarwechselrichter übermittelten Daten von diesen gesammelt werden und dass diese Daten entsprechend einer Adresszuordnung an die als Kommunikationsslave KS1...KSn bzw. KS11...KS1n, KS21...KS2m) ausgebildeten Solarwechselrichter geschickt werden und dass die Daten eines als Kommunikationsslave (KS1...KSn bzw. KS11...KS1n, KS21...KS2m) ausgebildeten Solarwechselrichters vom als Kommunikationsmaster (KM bzw. KM1, KM2) ausgebildeten Solarwechselrichter abgerufen und über die LAN-Schnittstelle an einen Knoten im Kommunikationsnetz (KN) geschickt werden.

8. Verfahren zum Betrieb einer Kommunikationsstruktur nach einem der Ansprüche 1 bis 6, **dadurch gekennzeichnet, dass** die Web-Server aller Solarwechselrichter (KM, KS1...KSn bzw. KM1, KM2, KS11...KS1n, KS21...KS2m) aktiv sind und alle Daten aus dem Kommunikationsnetz (KN) über die als Kommunikationsmaster (KM bzw. KM1, KM2) ausgebildeten Solarwechselrichter entsprechend einer Adresszuordnung an die als Kommunikationsslave (KS1...KSn bzw. KS11...KS1n, KS21...KS2m) ausgebildeten Solarwechselrichter weitergeleitet werden und dass die von einem als Kommunikationsslave (KS1...KSn bzw. KS11...KS1n, KS21...KS2m) ausgebildeten Solarwechselrichter gesendeten Daten über den zugeordneten, als Kommunikationsmaster (KM bzw. KM1, KM2) ausgebildeten Solarwechselrichter an einen Knoten im Kommunikationsnetz (KN) weitergeleitet werden.

9. Verfahren nach Anspruch 7 oder 8, **dadurch gekennzeichnet, dass** im ordnungsgemäßen Betrieb alle Daten der jeweils einem Kommunikationsmaster (KM bzw. KM1, KM2) zugeordneten Kommunikationsslaves (KS1...KSn bzw. KS11...KS1n, KS21...KS2m) über diesen Kommunikationsmaster (KM bzw. KM1, KM2) abgewickelt werden und dass bei einem Ausfall dieses Kommunikationsmasters (KM bzw. KM1, KM2) alle Daten über einen Ersatz-Kommunikationsmaster (KS1 bzw. KS11, KS21) abgewickelt werden.

## Claims

1. Communication structure for at least two solar inverters (KM, KS1...KSn or KM1, KM2, KS11...KS1n, KS21...KS2m), wherein at least one first solar inverter (KM or KM1, KM2) is connected by means of a first transmission medium (a) suitable for LAN networks via a LAN interface to a communication network (KN), **characterised in that** at least one further solar inverter (KS1...KSn or KS11...KS1n, KS21...KS2m) is connected to the first solar inverter (KM or KM1, KM2) via serial interfaces with bus capabilities and a corresponding second transmission medium (b) and that each of the solar inverters (KM, KS1...KSn or KM1, KM2, KS11...KS1n, KS21...KS2m) includes a Web server.

2. Communication structure according to claim 1, **characterised in that** the solar inverters connected to the communication network (KN) in each case are embodied as communication masters (KM or KM1, KM2) and that the further solar inverters are embodied as communication slaves (KS1...KSn or KS11...KS1n, KS21...KS2m).

3. Communication structure according to claim 1 or 2, **characterised in that** the LAN interface is embodied as an Ethernet interface and that the serial interface is embodied as an EIA-485 interface.

4. Communication structure according to one of the claims 1 to 3, **characterised in that**, for each communication master (KM or KM1, KM2) at least one standby communication master (KS1 or KS11, KS21) is provided, which operates in normal operation as communication slave and in the event of an error assumes the function of the communication master.

5. Communication structure according to one of the claims 1 to 4, **characterised in that** a router is switched between the communication network (KN) and the communication master (KM or KM1, KM2).

6. Communication structure according to one of the claims 1 to 5, **characterised in that** all solar inverters (KM, KS1...KSn or KM1, KM2, KS11...KS1n, KS21...KS2m) are identical in construction.

7. Method of operating a communication structure according to one of the claims 1 to 6, **characterised in that** only the Web servers of the solar inverters embodied as communication masters (KM or KM1, KM2) are active and all data transferred from the communication network (KN) via the LAN interfaces to the solar inverters embodied as communication masters (KM or KM1, KM2) is collected by these units and that this data is sent in accordance with an address assignment to the solar inverters embodied as communication slaves (KS1...KSn or KS11...KS1n, KS21...KS2m) and that the data of the solar inverters embodied as communication slaves (KS1...KSn or KS11...KS1n, KS21...KS2m) is retrieved by the solar inverters embodied as communication masters (KM or KM1, KM2) and sent via the LAN interface to a node in the communication network (KN).

8. Method for operating a communication structure according to one of the claims 1 to 6, **characterised in that** the Web servers of all solar inverters (KM, KS1...KSn or KM1, KM2, KS11...KS1n, KS21...KS2m) are active and all data is forwarded in accordance with an address assignment from the communication network (KN) via the solar inverters embodied as communication masters (KM or KM1, KM2) to the solar inverters embodied as communication slaves (KS1...KSn or KS11...KS1n, KS21...KS2m) and that the data sent from the solar inverters embodied as communication slaves (KS1...KSn or KS11...KS1n, KS21...KS2m) is forwarded via the assigned solar inverters embodied as communication masters (KM or KM1, KM2) to a node in the communication network (KN).

9. Method according to claim 7 or 8, **characterised in that**, in normal operation all data of the communication slaves (KS1...KSn or KS11...KS1n, KS21...KS2m) assigned to a communication master (KM or KM1, KM2) in each case is handled via these communication masters (KM or KM1, KM2) and that, on failure of this communication master (KM or KM1, KM2) all data is handled via a standby communication master (KS1 or KS11, KS21).

## Revendications

1. Structure de communication pour au moins deux onduleurs solaires (KM, KS1 ... KSn resp. KM1, KM2, KS11 ... KS1n, KS21 ... KS2m), au moins un premier onduleur solaire (KM resp. KM1, KM2) étant relié à un réseau de communication (KN) via une première interface LAN au moyen d'un premier moyen de transmission (a) adapté pour réseaux LAN, **caractérisée en ce qu'**au moins un autre onduleur solaire (KS1 ... KSn resp. KS11 ... KS1n, KS21 ... KS2m) est relié au premier onduleur solaire (KM resp. KM1, KM2) via des interfaces série aptes au bus et un deuxième moyen de transmission (b) et **en ce que** chaque onduleur solaire (KM, KS1 ... KSn resp. KM1, KM2, KS11 ... KS1n, KS21 ... KS2m) comprend un serveur Web.

2. Structure de communication selon la revendication 1, **caractérisée en ce que** les onduleurs solaires reliés au réseau de communication (KN) sont respectivement conçus en tant que maîtres de communication (KM resp. KM1, KM2) et **en ce que** les autres onduleurs solaires sont conçus en tant qu'esclaves de communication (KS1 ... KSn resp. KS11 ... KS1n, KS21 ... KS2m).

3. Structure de communication selon la revendication 1 ou 2, **caractérisée en ce que** l'interface LAN est conçue en tant qu'interface Ethernet et **en ce que** l'interface série est conçue en tant qu'interface EIA-485.

4. Structure de communication selon l'une des revendications 1 à 3, **caractérisée en ce qu'**est prévu, pour chaque maître de communication (KM resp. KM1, KM2), au moins un maître de communication de remplacement (KS1 resp. KS11, KS21) qui, en service normal, fonctionne en tant qu'esclave de communication et qui, en cas d'erreur, assure la fonction du maître de communication.

5. Structure de communication selon l'une des revendications 1 à 4, **caractérisée en ce qu'**un routeur est monté entre le réseau de communication (KN) et les maîtres de communication (KM resp. KM1, KM2).

6. Structure de communication selon l'une des revendications 1 à 5, **caractérisée en ce que** tous les onduleurs solaires (KM, KS1 ... KSn resp. KM1, KM2, KS11 ... KS1n, KS21 ... KS2m) sont de construction identique.

7. Procédé d'exploitation d'une structure de communication selon l'une des revendications 1 à 6, **caractérisé en ce que** seuls les serveurs Web des onduleurs solaires conçus en tant que maîtres de communication (KM resp. KM1, KM2) sont actifs et que toutes les données transmises du réseau de communication (KN) aux onduleurs solaires conçus en tant que maîtres de communication (KM resp. KM1, KM2) via les interfaces LAN sont collectées par ceux-ci et **en ce que** ces données sont envoyées, conformément à une affectation d'adresse, aux onduleurs solaires conçus en tant qu'esclaves de communication (KS1 ... KSn resp. KS11 ... KS1n, KS21 ... KS2m) et **en ce que** les données d'un onduleur solaire conçu en tant qu'esclave de communication (KS1 ... KSn resp. KS11 ... KS1n, KS21 ... KS2m) sont appelées par l'onduleur solaire conçu en tant que maître de communication (KM resp. KM1, KM2) et envoyées à un noeud du réseau de communication (KN) via l'interface LAN.

8. Procédé d'exploitation d'une structure de communication selon l'une des revendications 1 à 6, **caractérisé en ce que** les serveurs Web de tous les onduleurs solaires (KM, KS1 ... KSn resp. KM1, KM2, KS11 ... KS1n, KS21 ... KS2m) sont actifs et que toutes les données sont retransmises, conformément à une affectation d'adresse, du réseau de communication (KN) aux onduleurs solaires conçus en tant qu'esclaves de communication (KS1 ... KSn resp. KS11 ... KS1n, KS21 ... KS2m) via les onduleurs solaires conçus en tant que maîtres de communication (KM resp. KM1, KM2) et **en ce que** les données émises par un onduleur solaire conçu en tant qu'esclave de communication (KS1 ... KSn resp. KS11 ... KS1n, KS21 ... KS2m) sont retransmises à un noeud du réseau de communication (KN) via l'onduleur solaire associé conçu en tant que maître de communication (KM resp. KM1, KM2).

9. Procédé selon la revendication 7 ou 8, **caractérisé en ce que**, en service normal, toutes les données des esclaves de communication (KS1 ... KSn resp. KS11 ... KS1n, KS21 ... KS2m) associés respectivement à un maître de communication (KM resp. KM1, KM2) sont effectuées par ce maître de communication (KM resp. KM1, KM2) et **en ce que**, en cas de défaillance de ce maître de communication (KM resp. KM1, KM2), toutes les données sont effectuées par un maître de communication de remplacement (KS1 resp. KS11, KS21).
